# EUROPÄISCHE PATENTSCHRIFT

(11) **EP 0 535 003 B1**
(45) Veröffentlichungstag und Bekanntmachung des Hinweises auf die Patenterteilung: **12.10.1994**
(21) Anmeldenummer: 91909745.1
(22) Anmeldetag: 27.05.1991
(51) Int. Cl.: H05K 5/00, H01R 13/508

(54) **ELEKTRISCHES GERÄT, INSBESONDERE SCHALT- UND STEUERGERÄT FÜR KRAFTFAHRZEUGE**
ELECTRICAL DEVICE, IN PARTICULAR SWITCHING AND CONTROL DEVICE FOR MOTOR VEHICLES
APPAREIL ELECTRIQUE, EN PARTICULIER APPAREIL DE COMMUTATION ET DE COMMANDE POUR VEHICULES AUTOMOBILES

(30) Priorität: 20.06.1990 DE 4019570
(43) Veröffentlichungstag der Anmeldung: 07.04.1993
(73) Patentinhaber: ROBERT BOSCH GMBH, 70442 Stuttgart (DE)
(72) Erfinder: HUSSMANN, Dieter, D-7141 Steinheim (DE); JESSBERGER, Thomas, D-7147 Eberdingen (DE); KARR, Dieter, D-7533 Tiefenbronn (DE); KLEIN, Gerhard, D-3170 Gifhorn (DE)
(86) Internationale Anmeldenummer: DE9100446
(87) Internationale Veröffentlichungsnummer: WO9120177

(56) Entgegenhaltungen:
- DE-B- 1 297 725
- FR-A- 2 530 396

## Beschreibung

### Stand der Technik

Die Erfindung geht aus von einem elektrischen Gerät nach der Gattung des Hauptanspruchs.

Bei einem nach der DE-OS 33 10 477 bekannten elektrischen Gerät dieser Art ist ein Steckerkörper in einer kranzförmigen Stirnplatte verschraubt. Dabei ist zwischen der Stirnplatte und dem Steckerkörper eine Dichtung angeordnet. Die Stirnplatte und der angeschraubte Steckerkörper sind weiterhin in einem Gehäuse angeordnet und durch Rastmittel mit diesem verbunden. Zwischen Gehäuserand und Stirnplatte ist ebenfalls eine Dichtung eingelegt. Dieses elektrische Gerät hat den Nachteil, daß an den Verschraubungen zwischen Stirnplatte und Steckerkörper Dichtprobleme auftreten, die durch die eingelegten Dichtungen zwischen Stirnplatte und Steckerkörper bzw. zwischen Gehäuserand und Stirnplatte nicht beeinflußt werden.

### Vorteile der Erfindung

Das erfindungsgemäße elektrische Gerät mit den kennzeichnenden Merkmalen des Hauptanspruchs hat demgegenüber den Vorteil, daß die Verbindung zwischen Steckerkörper und Stirnplatte mit Hilfe einer Dichtung hinreichend gut abgedichtet werden kann, da die Verbindung ohne nach außen durchgehende Bohrungen erfolgt. Mit Hilfe des keilförmigen Bereichs der Zinken des Arretierkammes kann mit geringem Kraftaufwand und mit im Gegensatz zur geschraubten Verbindung geringem Montageaufwand eine sichere und dichte Verbindung geschaffen werden.

### Zeichnung

Ein Ausführungsbeispiel der Erfindung ist in der nachfolgenden Beschreibung und Zeichnung näher erläutert. Letztere zeigt in Figur 1 einen Längsschnitt durch ein teilweise dargestelltes elektrisches Steuergerät, Figur 2 und 3 zeigen Ansichten eines Arretierkammes.

### Beschreibung des Ausführungsbeispiels

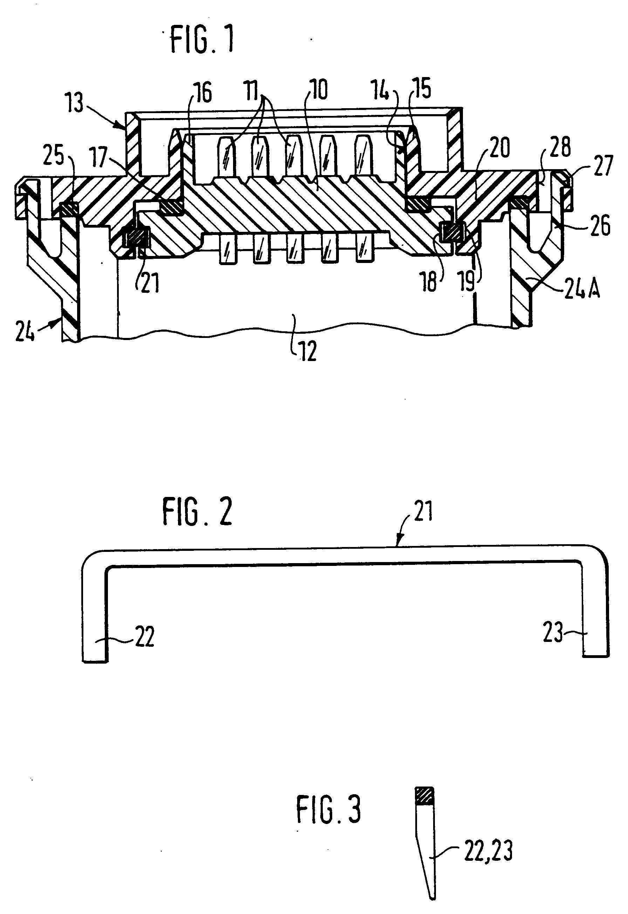

In Figur 1 ist mit 10 die Frontpartie eines Steckerkörpers bezeichnet, in dem eine Vielzahl von gegeneinander abgedichteten und isolierten Flachsteckern 11 eingebettet sind, deren innere Enden mit einer Leiterplatte 12 verbunden sind. Eine kranzförmige Stirnplatte 13 ist mit einer Öffnung 14 versehen, welche durch eine Ringwand 15 begrenzt ist. In dieser Öffnung 14 ist der Steckerkörper 10 mit einem entsprechend ausgebildeten Kragen 16 aufgenommen.

Zwischen Steckerkörper 10 und Stirnplatte 13 ist eine Dichtung 17 angeordnet. Im Außenrand des Steckerkörpers 10 ist eine Nut 18 ausgebildet, der eine entsprechende Nut 19 in einem inneren Kragenteil 20 der Stirnplatte 13 gegenüberliegt. In diese einander gegenüberliegende Nuten 18, 19 ist ein in Figur 2 und 3 dargestellter Arretierkamm 21, dessen Zinken 22, 23 keilförmig ausgebildet sind, eingeschoben. Durch die keilförmige Ausbildung der Zinken 22, 23 erfolgt eine Pressung der vormontierten Dichtung 17 zwischen Stirnplatte 13 und Steckerkörper 10 und somit ein Abdichten der Öffnung 14 in der Stirnplatte 13. Durch vollständiges Einschieben des Kammes 21 erfolgt eine nahezu formschlüssige Verbindung der beiden Bauteile 10 und 13.

Die so miteinander verbundene Baueinheit ist in das Steuergerätegehäuse 24 eingeschoben. Der Arretierkamm 21 ist dazu so ausgebildet, daß dies nur bei vollständig in die Nuten 18, 19 eingeschobenem Kamm 21 möglich ist. Gleichzeitig wird der Arretierkamm 21 nach dem Einschub der verbundenen Baueinheit in das Gehäuse 24 in seiner Lage fixiert.

Zwischen Gehäuserand 24A und Stirnplatte 13 ist eine Dichtung 25 angeordnet, die das Eindringen von Schmutz und Feuchtigkeit verhindert. Die Verbindung zwischen Stirnplatte und Gehäuse kann beispielsweise, wie dargestellt, durch Rastzungen 26 mit nach außen gerichteten Nasen 27 erfolgen, die am Gehäuserand 24A ausgebildet sind und in entsprechende Aussparungen 28 in der Stirnplatte einrasten.

## Patentansprüche

1. Elektrisches Gerät, insbesondere Schalt- und Steuergerät für Kraftfahrzeuge, mit einem Gehäuse (24) und mit an einer Stirnseite in einem Steckerkörper (10) angeordneten, voneinander isolierten Steckerteilen (11), bei dem der Steckerkörper (10) durch eine kranzförmige Öffnung (14) in einer Stirnplatte (13) ragt und an dieser befestigt ist und die Stirnplatte wiederum am Rand des Gehäuses (24) befestigt ist, dadurch gekennzeichnet, daß die Verbindung zwischen Stirnplatte (13) und Steckerkörper (10) durch einen Arretierkamm (21) erfolgt, der in passende einander gegenüberliegende Nuten (18, 19) im Steckerkörper (10) und in der Stirnplatte (13) eingeschoben ist, und daß der Arretierkamm (21) so ausgebildet ist, daß der mit der Stirnplatte (13) verbundene Steckerkörper (10) nur in das Gehäuse (24) eingeschoben werden kann, wenn der Arretierkamm (21) vollständig in die Nuten (18, 19) eingeschoben ist und daß dieser danach vom Gehäuse (24) in seiner Lage fixiert wird.

2. Elektrisches Gerät nach Anspruch 1, dadurch gekennzeichnet, daß der Arretierkamm (21) keilförmig ausgebildete Zinken (22, 23) aufweist.

## Claims

1. Electrical device, in particular a switching and control device for motor vehicles, with a housing (24) and with plug parts (11) arranged on a front face in a plug body (10) and insulated from each other, in which the plug body (10) projects through a collar-like aperture (14) in a front plate (13) and is fixed to the same, and the front plate in turn is fixed to the edge of the housing (24), characterized in that the connection between the front plate (13) and the plug body (10) is made by a stop comb (21), which is pushed into suitable grooves (18, 19) which face each other, in the plug body (10) and in the front plate (13), and in that the stop comb (21) is designed such that the plug body (10) which is connected to the front plate (13) can be inserted into the housing (24) only when the stop comb (21) is fully pushed into the grooves (18, 19), and in that it is then fixed in its position by the housing (24).

2. Electrical device according to Claim 1, characterized in that the stop comb (21) has wedge-shaped teeth (22, 23).

## Revendications

1. Appareil électrique, notamment appareil de commutation et de commande pour des véhicules automobiles, comportant un boîtier (24) avec, au niveau de sa face frontale, des broches (11) isolées les unes des autres, montées dans le corps (10) de prise, le corps (10) pénétrant dans la plaque frontale (13) par une ouverture (14) en forme de couronne en étant fixé à cette plaque frontale, cette plaque étant elle-même fixée au bord du boîtier (24), caractérisé en ce que la liaison entre la plaque frontale (13) et le corps de prise (10) se fait par un peigne de blocage (21) introduit dans des rainures (18, 19) opposées, adaptées, réalisées dans le corps de prise (10) et dans la plaque frontale (13), le peigne (21) est réalisé pour que le corps de prise (10) relié à la plaque (13) ne puisse être introduit dans le boîtier (24) que si le peigne de blocage (21) est glissé complètement dans les rainures (18, 19) pour être alors bloqué dans sa position par le boîtier 24.

2. Appareil électrique selon la revendication 1, caractérisé en ce que le peigne de blocage (21) comporte des dents (22, 23) en forme de coins.
